# EUROPEAN PATENT APPLICATION

(11) **EP 1 130 926 A2**
(43) Date of publication of application: **05.09.2001**
(21) Application number: 01200827.2
(22) Date of filing: 05.03.2001
(51) Int. Cl.: H04N 7/50

(54) **Variable length decoding system and method**

(30) Priority: 03.03.2000 US 186789 P
(71) Applicant: Texas Instruments Incorporated, Dallas, Texas 75251 (US)
(72) Inventor: Zhou, Minhua, Plano, TX 75093 (US)
(74) Representative: Holt, Michael

(57) **Abstract**

A method of decoding variable length codes by converting a variable code table into a variable length decoding code table plus control table from which a universal variable length decoder can decode.

## Description

### BACKGROUND OF THE INVENTION

The present invention relates to electronic systems, and more particularly, to digital systems and methods with bitstreams representing coded information with codewords of variable length.

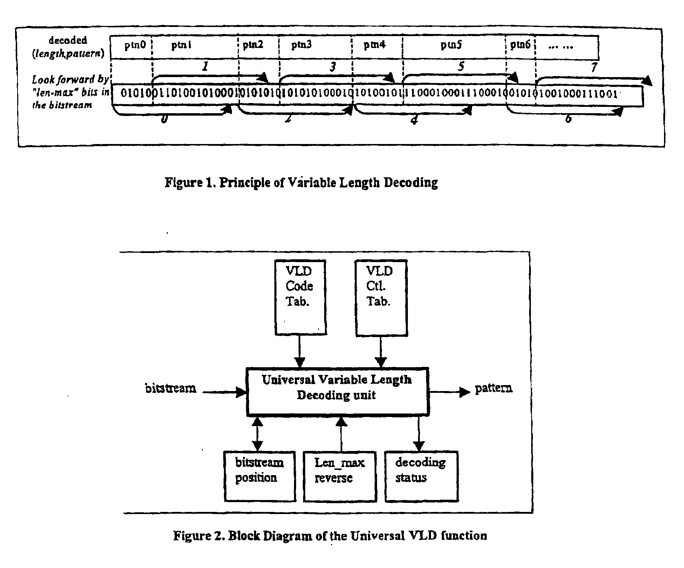

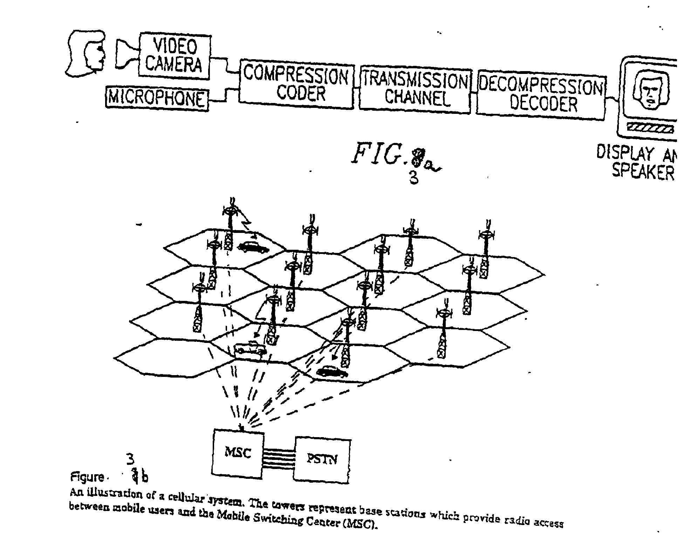

The current rapid expansion of digital communication (speech, video, data) relies on increasingly economical digital signal processing and efficient transmission and storage. For example, video communication has general functionality as illustrated in Figure 3a, and increasingly includes a link through the air interface as illustrated in Figure 3b. Many digital communication systems and standards, such as MPEG, use coding with variable length codewords for coding efficiency. Variable length decoding (VLD) is needed for decoding bitstreams whenever variable length coding (VLC) is used by the encoder for generating the bitstreams. A variable length code table typically has entries represented by (codeword length, pattern or information encoded, variable length codeword: vlc_code). The VLD is to determine (length, pattern) based on the vlc_code value extracted from the bitstream where vlc_code value means the value of the vlc_code codeword when interpreted as a binary number. Figure 1 illustrates the principle of VLD. To find and decode the next codeword, the decoder looks at the sequence of bits forward from the current bitstream position by a fixed length of bits (usually it is the maximal code length "len_max" of the entire VLC table). Based on the extracted vlc_code value, the VLD determines (length, pattern) by look up in the VLD table, then updates the current decoding position in the bitstream according to the decoded codeword length, and starts to decode the next codeword.

Normally, a decoder includes several VLDs because VLC tables are different from table to table, and VLD functions have to be implemented differently according to the contents of the VLC tables. For a decoder implementation this implies large code size (or high gate count for hardware solutions) and long development times. Therefore, there is a demand to have a universal VLD method that is able to deal with any VLC table in order to reduce costs and increase flexibility in decoder design.

Obviously, the simplest way to do universal VLD is with the direct VLD table look up; that is, each possible sequence of len_max bits in the bitstream is an index to a table entry containing the next codeword length and pattern (information coded). However, this requires a huge VLD table size: indeed, a table with 2^{len_max} entries. For example, if the maximum codeword size of a VLC table is 16 bits (i.e., len_max = 16), such a VLD table would have 64 K entries. This is too expensive in terms of memory size.

### SUMMARY OF THE INVENTION

The present invention provides a universal VLD method including a VLD table construction function and a universal VLD function. The universal VLD function is valid for any VLD as long as the VLD tables are produced by using the VLD table construction function.

This has the advantage of smaller VLD size because a single VLD function can decode multiple VLC codes.

### BRIEF DESCRIPTION OF THE DRAWINGS

The present invention will now be further described, by way of example, with reference to the preferred and exemplary embodiments illustrated in the figures of the accompanying drawings in which:
Figure 1 illustrates variable length decoding (VLD).
Figure 2 is a block diagram of a preferred embodiment decoding system.
Figures 3a-3b show general digital communication which could use preferred embodiment decoding.

### DETAILED DESCRIPTION OF THE PREFERRED EMBODIMENTS

### 1. Overview

The preferred embodiments provide a variable length decoding (VLD) table construction function plus a universal VLD function.
This construction function is used to construct a VLD code table and a VLD control table for a given variable length coding (VLC) table, and the universal VLD function uses these two tables to decode. The VLD code table is an array of entries (length, pattern), while the VLD control table is used to address the coding entry in the VLD code table.

### 2. VLD code table and VLD control table construction

Basically, there are two kinds of VLC tables in terms of vlc codes: 0-leading tables (e.g. Table 1) and 1-leading tables (e.g. Table 4). The constructions of VLD code and control tables for these two different kinds of VLC tables are different, but similar. First consider the VLD table construction function for a 0-leading VLC table such as the following Table 1.

**Table 1.**

| VLC table of MPEG1 Macroblock_address_increment | | |
|---|---|---|
| length | pattern (macroblock_address_ increment) | vlc_code |
| 1 | 1 | 1 |
| 3 | 2 | 011 |
| 3 | 3 | 010 |
| 4 | 4 | 0011 |
| 4 | 5 | 0010 |
| 5 | 6 | 00011 |
| 5 | 7 | 00010 |
| 7 | 8 | 0000111 |
| 7 | 9 | 0000110 |
| 8 | 10 | 00001011 |
| 8 | 11 | 00001010 |
| 8 | 12 | 00001001 |
| 8 | 13 | 00001000 |
| 8 | 14 | 00000111 |
| 8 | 15 | 00000110 |
| 10 | 16 | 1 000001011 |
| 10 | 17 | 0 000001011 |
| 10 | 18 | 1 000001010 |
| 10 | 19 | 0 000001010 |
| 10 | 20 | 1 000001001 |
| 10 | 21 | 0 000001001 |
| 11 | 22 | 11 000001000 |
| 11 | 23 | 10 000001000 |
| 11 | 24 | 01 000001000 |
| 11 | 25 | 00 000001000 |
| 11 | 26 | 00000011111 |
| 11 | 27 | 000000111 10 |
| 11 | 28 | 000000111 01 |
| 11 | 29 | 000000111 00 |
| 11 | 30 | 000000110 11 |
| 11 | 31 | 000000110 10 |
| 11 | 32 | 000000110 01 |
| 11 | 33 | 000000110 00 |

Table 1 is a 0-leading VLC table which is used for VLC of the MPEG1 macroblock_address_increment. This table is used as an example to explain how to construct the VLD code and control tables from a given VLC table.

The basic idea is to divide the VLC table into a set of sub-tables in a defined order according to the vlc_code values. The sub-tables make up the VLD code table. For each sub-table there will be a field to indicate the location of the sub-table in the VLD code table. Those fields build up the VLD control table.

The following eight steps are involved in the construction of the VLD code table and the VLD control table:
1. Get the maximal codeword length (len_max) of the VLC table (e.g. len_max = 11 for Table 1).
2. Left shift each VLC codeword (vlc_code) in the VLC table by (len_max - length) bits. For example, the first entry in Table 1 has a length of 1, so its VLC codeword is left-shifted by 10 bits. The VLC codeword (vlc_code) value after shifting is 1024 (see column of "shifted value" in following Table 2). That is, treat the right shifting as adding 10 0-bits, so the shifted codeword is 1000 0000 000 which as a binary number equals 1024.
3. Reorder the shifted VLC codewords into increasing order according to the vlc_code values after shifting (see column of "shifted value" in Table 2).
4. Divide the VLC table into sub-tables according to the shifted values. A reorganized VLC codeword is classified into sub-table n if its shifted value satisfies 2ⁿ⁻¹ ≤ value < 2ⁿ. Sub-table 0 is an exception, which contains only one zero element. By classifying sub-tables in this way it is easy to identify to which sub-table index a given shifted value belongs, because the sub-table index can be simply determined by checking the MSB position of the shifted value. Note also that the sub-table number for vlc_code is simply 11 - (the number of leading 0s in vlc_code).
5. Fill up the leaks in each sub-table. Leaks are defined as the code entries that are valid but not used in the VLC table. For example, in Table 2 all the entries in sub-tables 0~4 and the entries below shifted value 24 in sub-table 5 are missing, because those entries are not used in the VLC table (see Table 1). For the purpose of error detection, those leaks must be filled with dummy codewords. In Table 2, the leaks are filled with the dummy code (0,0) for (length, pattern). Whenever a decoder extracts a dummy code (0,0) from the bitstream, it will report a finding of error.
6. Determine "shift" for each sub-table where "shift" for a sub-table is defined as the difference between len_max and the maximal length of the codewords in the sub-table. For example, sub-table 6 of Table 2 has codewords varying in length from 8 to 11 bits, thus "shift" equals 0 The VLD control table has "shift" as the first field component; see Table 2, column of VLD-control (shift, offset).
7. Determine the entry indices in the VLD code table by simple enumeration starting at 0 in sub-table 0. Each element (length, pattern) is repeated 2^{len_max-shift-length} times in the VLD code table. As an example, in sub-table 7 of Table 2, (7, 8) appears twice in the VLD code table because (len_max = 11, shift = 3, length = 7). That is, the indices 70 and 71 both appear for (7,8). This repetition accounts for the unequal length of codewords in the sub-table.
8. Determine "offset" for each sub-table so that any entry in the sub-table can find its index in the VLD code table by the equation: index = offset + (value » shift), where "value" is the "shifted value" in Table 2. Thus "offset" for a sub-table aligns the index with the unshifted value. Note that decoding "shifted value" here is equivalent to the value of the sequence of "len_max" bits starting at the current decoding position in the bitstream in that the binary value of the len_max bits is in the range of the sub-table. For example, the second entry of sub-table 10 of Table 2 has shift 8, index 77, and vlc_code 011- ---- ---; the 8 -'s are the left shift of 8, so (value » shift) is 3 (binary 011) and offset = index - (value » shift) =77 - 3 = 74. The VLD control table has "offset" as the second field component.

**Table 2.**

| Design of VLD code table and VLD control table for MPEG1 Macroblock_address_increment | | | | |
|---|---|---|---|---|
| VLD control (shift,offset ) | VLD code index | VLD code (length,patter n) | Re-organized vlc_code | shifted value |
| Sub-table0 (0~0) | | | | |
| (0,0) | 0~0 | ( 0, 0) | 0000 0000 | 0 |
| | | | 000 | |
| Sub-tablel (1~1) | | | | |
| (0,0) | 1~1 | ( 0, 0) | 0000 0000 | 1 |
| | | | 001 | |
| Sub-table2 (2~3) | | | | |
| (0,0) | 2~3 | ( 0, 0) | 0000 0000 | 2~3 |
| | | ( 0, 0) | 010 | |
| | | | 0000 0000 | |
| | | | 011 | |
| Sub-table3 (4~7) | | | | |
| (0,0) | 4~7 | ( 0, 0) | 0000 0000 | 4~7 |
| | | ∼ | 100 | |
| | | ( 0, 0) | ~ | |
| | | | 0000 0000 | |
| | | | 111 | |
| Sub-table4 (8~15) | | | | |
| (0,0) | 8~15 | ( 0, 0) | 0000 0001 | 8~15 |
| | | ~ | 000 | |
| | | (0, 0) | ~ | |
| | | | 0000 0001 | |
| | | | 111 | |
| Sub-table5 (16~31) | | | | |
| (0,0) | 16~23 | ( 0, 0) | 0000 0010 | 16~23 |
| | | ~ | 000 | |
| | | ( 0, 0) | ~ | |
| | | | 000 0010 | |
| | | | 111 | |
| | 24 | (11,33) | 0000 0011 | 24 |
| | | | 000 | |
| | 25 | (11,32) | 0000 0011 | 25 |
| | | | 001 | |
| | 26 | (11,31) | 0000 0011 | 26 |
| | | | 010 | |
| | 27 | (11,30) | 0000 0011 | 27 |
| | | | 011 | |
| | 28 | (11,29) | 0000 0011 | 28 |
| | | | 100 | |
| | 29 | (11,28) | 0000 0011 | 29 |
| | | | 101 | |
| | 30 | (11,27) | 0000 0011 | 30 |
| | | | 110 | |
| | 31 | (11,26) | 0000 0011 | 31 |
| | | | 111 | |
| Sub-table6 (32~63) | | | | |
| (0,0) | 32 | (11,25) | 0000 0100 | 32 |
| | | | 000 | |
| | 33 | (11,24) | 0000 0100 | 33 |
| | | | 001 | |
| | 34 | (11,23) | 0000 0100 | 34 |
| | | | 010 | |
| | 35 | (11,22) | 0000 0100 | 35 |
| | | | 011 0100 | |
| | 36~37 | (10,21) | 0000 0100 | 36 |
| | | | 10- | |
| | 38-39 | (10,20) | 0000 0100 | 38 |
| | | | 11- | |
| | 40-41 | (10,19) | 0000 0101 | 40 |
| | | | 00- | |
| | 42~43 | (10,18) | 0000 0101 | 42 |
| | | | 01- | |
| | 44~45 | (10,17) | 0000 0101 | 44 |
| | | | 10- | |
| | 46~47 | (10,16) | 0000 0101 | 46 |
| | | | 11- | |
| | 48~55 | ( 8,15) | 0000 0110 - | 48 |
| | | | | |
| | 56~63 | ( 8,14) | 0000 0111 - | 56 |
| | | | | |
| Sub-table7 (64~127) | | | | |
| (3,56) | 64 | ( 8,13) | 0000 1000 - | 64 |
| | | | | |
| | 65 | ( 8,12) | 0000 1001 - | 72 |
| | | | | |
| | 66 | ( 8,11) | 0000 1010 - | 80 |
| | | | | |
| | 67 | ( 8,10) | 0000 1011 - | 88 |
| | | | | |
| | 68~69 | ( 7, 9) | 0000 110- - | 96 |
| | | | | |
| | 70~71 | ( 7, 8) | 0000 111- - | 112 |
| | | | | |
| Sub-table8 (128~255) | | | | |
| (6,70) | 72 | ( 5, 7) | 0001 0--- - | 128 |
| | | | | |
| | 73 | ( 5, 6) | 0001 1--- - | 192 |
| | | | | |
| Sub-table9 (256-511) | | | | |
| (7,72) | 74 | ( 4, 5) | 0010 ---- - | 256 |
| | 75 | ( 4, 4) | 0011 ---- - | 384 |
| | | | | |
| Sub-table10 (512-1023) | | | | |
| (8,74) | 76 | ( 3, 3) | 010- ---- - | 512 |
| | | | | |
| | 77 | ( 3, 2) | 011- ---- - | 768 |
| | | | | |
| Sub-tablell (1024~2047) | | | | |
| (10,77) | 78 | ( 1, 1) | 1--- ---- - | 1024 |

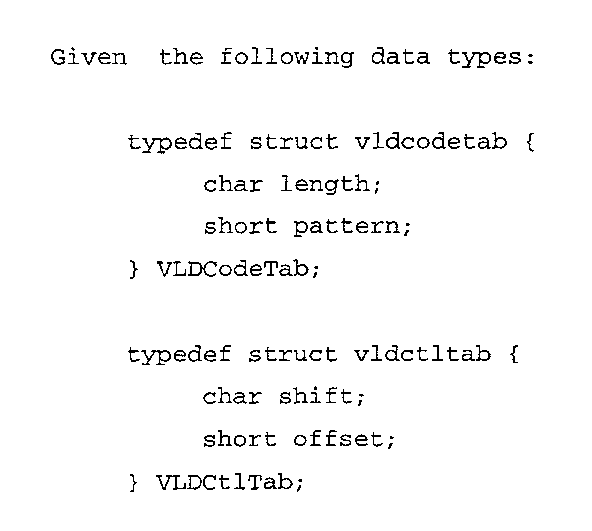

VLD code table and VLD control table for VLC Table 1 are shown in Table 3.

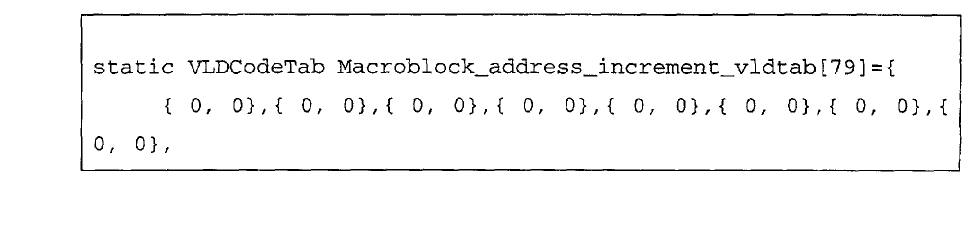

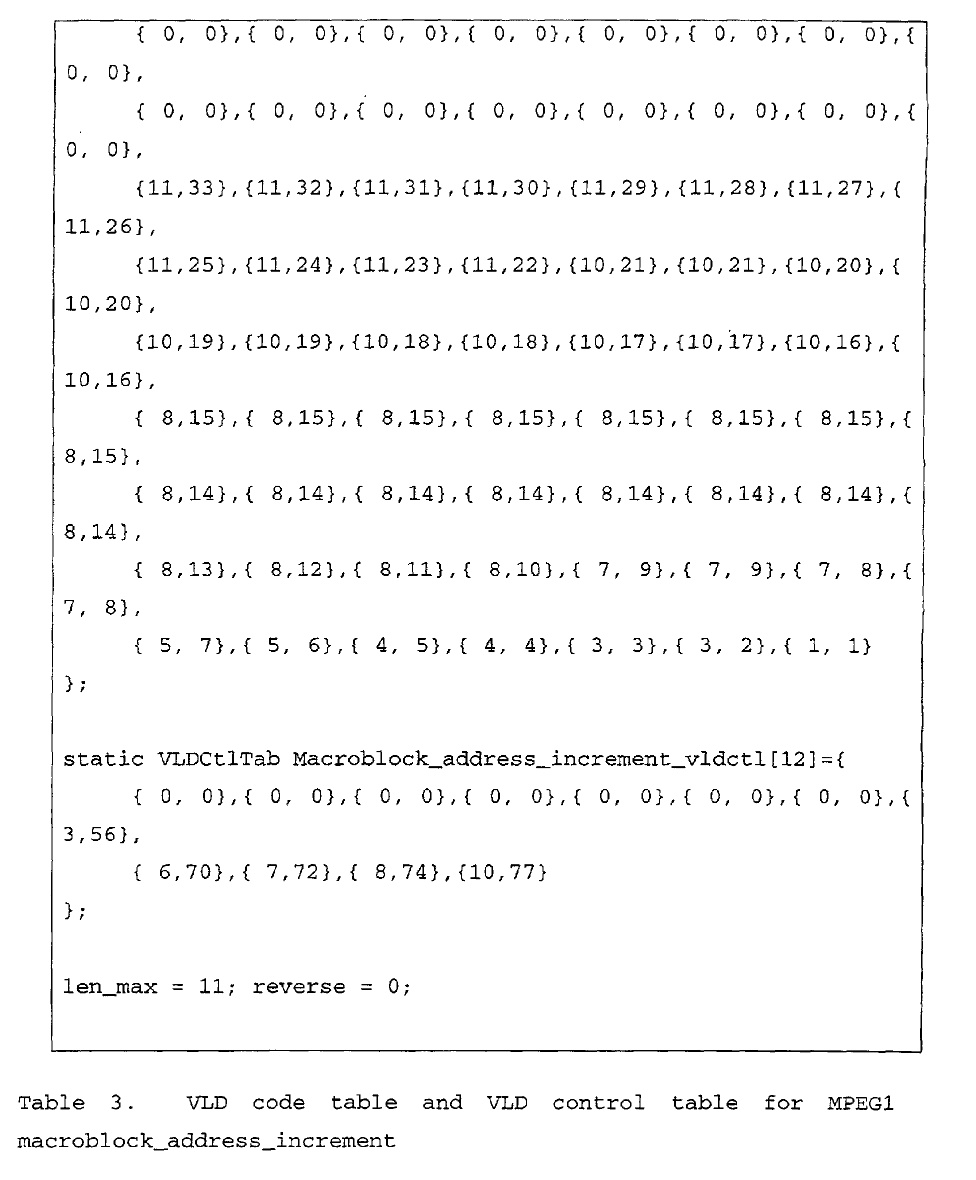

That is, the VLD construction function converts VLC Table 1 into VLD code table and VLD control table shown in Table 3. And decoding with the universal VLD function will be described below.

Now consider the VLD construction function applied to a 1-leading VLC table.

**Table 4.**

| VLD table of MPEG1 dct_dc_size_luminance | | |
|---|---|---|
| lengt h | pattern (dct_dc_size_luminance) | vlc_code |
| 3 | 0 | 100 |
| 2 | 1 | 00 |
| 2 | 2 | 01 |
| 3 | 3 | 101 |
| 3 | 4 | 110 |
| 4 | 5 | 1110 |
| 5 | 6 | 11110 |
| 6 | 7 | 111110 |
| 7 | 8 | 1111110 |

Table 4 illustrates an example of a 1-leading VLC table which is used for the MPEG1 dct_dc_size_luminance. The VLD table construction for a 1-leading VLC table is similar to that of a 0-leading VLC-table. The difference lies in reorganization of the vlc_codes. In a 1-leading table, the shifted value of a vlc_code is computed by first performing a bit-reversal (interchange 0 and 1) of the vlc_code followed by a left shift of (len_max - length) bits (see Table 5, column "shifted value"), where "length" is the codeword length of vlc_code. After this computation of shifted value, the same steps as described above are used to form the VLD code table and the VLD control table: see Table 5 and Table 6.

**Table 5.**

| Design of VLD code table and VLD control table for MPEG1 dct_dc_size_luminance | | | | | |
|---|---|---|---|---|---|
| VLD control (shift, offset ) | VLD code index | VLD code (length,patter n) | Re-organized vlc_code | | Shifted Value |
| Sub-table0 (0~0) | | | | | |
| (0,0) | 0 | ( 0, 0) | 1111 | 111 | 0 |
| Sub-tablel (1∼1) | | | | | |
| (0,0) | 1 | (7, 8) | 1111 | 110 | 1 |
| Sub-table2 (2∼3) | | | | | |
| (1,1) | 2 | (6, 7) | 1111 | 10- | 2 |
| Sub-table3 (4~7) | | | | | |
| (2,2) | 3 | ( 5, 6) | 1111 | 0-- | 4 |
| Sub-table4 (8∼15) | | | | | |
| (3,3) | 4 | ( 4, 5) | 1110 | --- | 8 |
| Sub-table5 (16~31) | | | | | |
| (4,4) | 5 | ( 3, 4) | 110- | --- | 16 |
| Sub-table6 (32∼63) | | | | | |
| (4,4) | 6 | ( 3, 3) | 101- | --- | 32 |
| | 7 | ( 3, 0) | 100- | --- | 48 |
| Sub-table7 (64~127) | | | | | |
| (5,6) | 8 | ( 2, 2) | 01-- | --- | 64 |
| | 9 | ( 2, 1) | 00-- | --- | 96 |

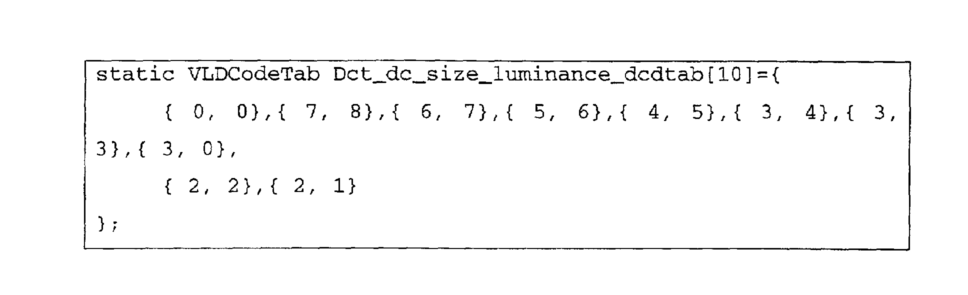

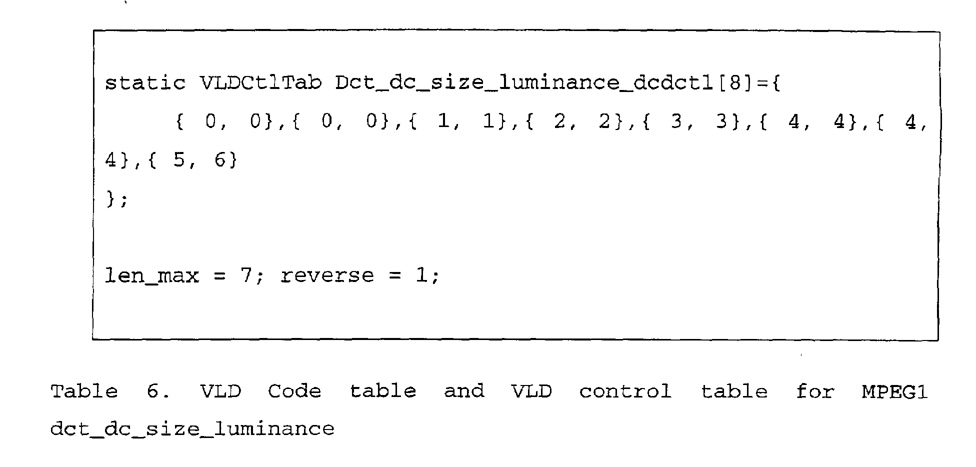

As Table 3 and Table 6 show, the size of a VLD control table is fixed, which has "len_max + 1" entries. However, the size of a VLD code table varies from table to table, it depends on the VLC table characteristics.

The construction of the VLD code table and the VLD control table as in the foregoing for any given VLC table can be automated; this includes the decision whether the input VLC table is treated as a 0-leading table or a 1-leading table.

### 3. Universal VLD function

After the VLD code table and the VLD control table are generated, a universal VLD function can be implemented. Table 7 illustrates the pseudo code for the implementation of universal VLD function.

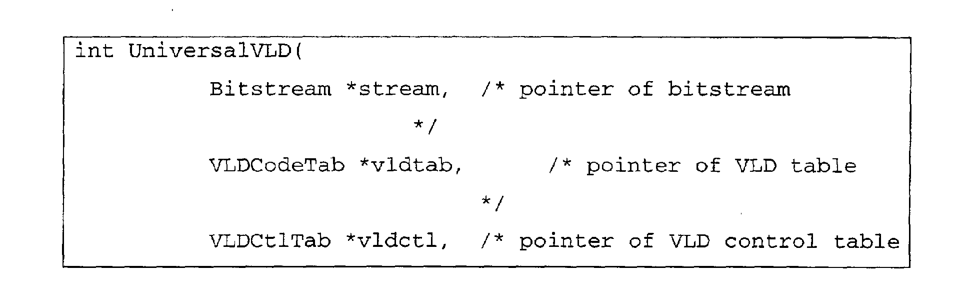

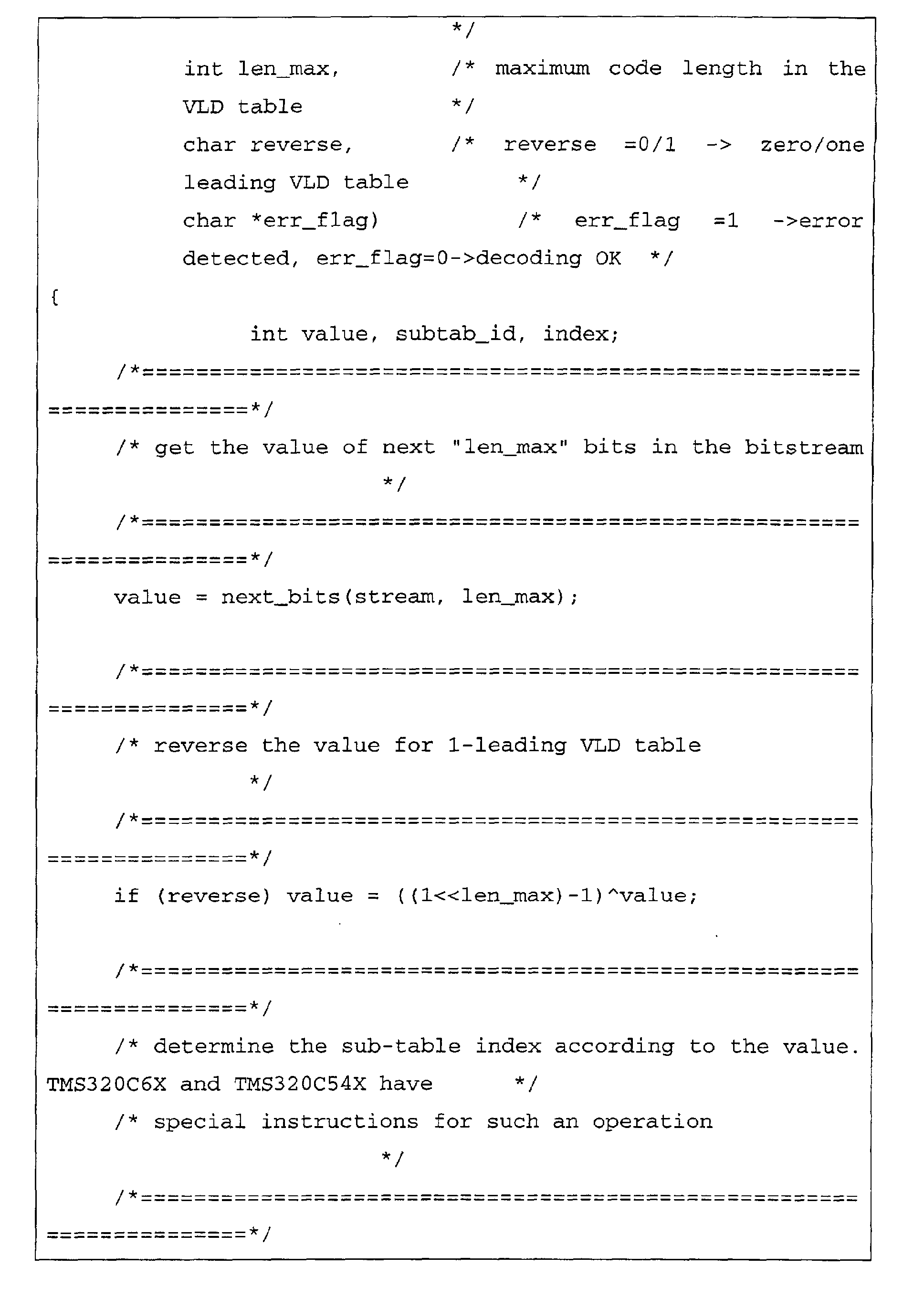

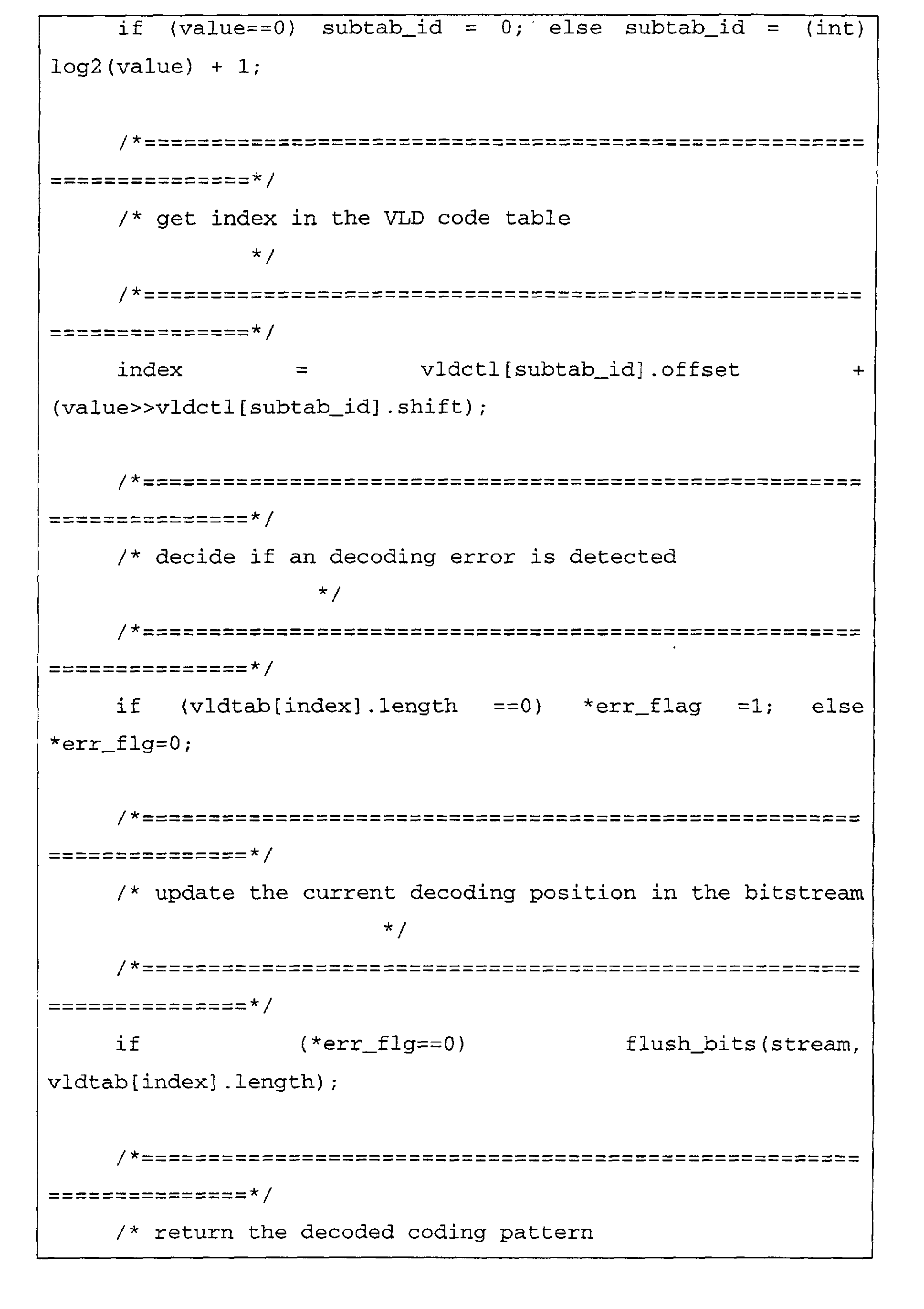

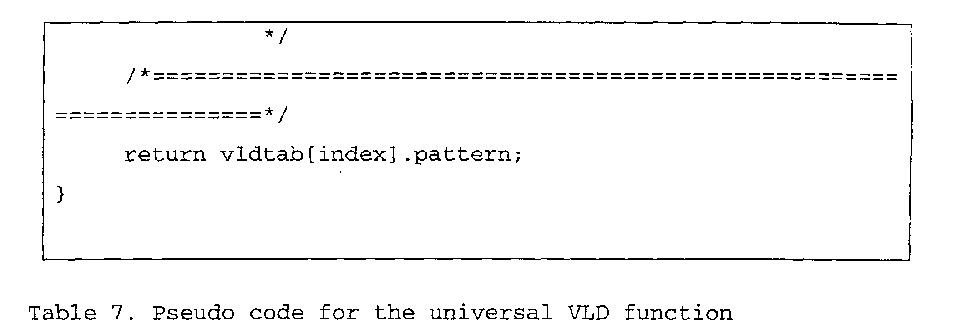

The universal VLD function contains the following seven steps:
1. Get the "value" of the next "len_max" bits in the bitstream.
2. If the VLD table is a 1-leading table, reverse the "value".
3. Determine the sub-table number according to the "value".
4. Get the index in the VLD code table by using the "value" and the sub-table control parameters (shift, offset).
5. Detect if an error occurs in the bitstream by checking the decoded code length.
6. If the decoding is error free, update the current decoding position in the bitstream by using the decoded code length.
7. Return the code pattern.

This function is universal in the sense that it can deal with any VLD provided that its VLD code table and VLD control table are constructed according to the foregoing description. Further, this function has the ability to perform error detection.

Figure 2 is a block diagram of the universal VLD function. The core of this function is the universal VLD unit, which incudes data memory and registers connected to it. The data memory is used to store the VLD code table and the VLD control table, while the three registers are used to store the bitstream decoding position, len_max/reverse, and the decoding status (i.e. err_flag). To decode a coded pattern, the universal VLD unit points to the related VLD code table and VLD control table, then extracts the coded pattern from the bitstream according to the given bitstream position and len_max/reverse. After decoding the pattern, the bitstream position register as well as the decoding status register are updated.

The preferred embodiment universal VLD method is made up of two functions: a VLD table construction function and a universal VLD function. The VLD table construction function is a generator of the VLD code table and the VLD control table according to the given VLC-table. The universal VLD function is valid for any VLD as long as its VLC table is transformed into a VLD code table and a VLD control table according to the foregoing format. In addition, it provides the error detection ability that is essential for VLDs in real applications. This method helps reduce the decoder complexity, costs and development time. A programmable VLD hardware solution can also be developed based on the preferred embodiment methods.

### 4. Modifications

Various modifications can be made to the preferred embodiments while retaining the features of a conversion of a VLC table into a VLD code table plus VLD control table so that a universal VLD decode function can decode. In particular, the partitioning of a variable length code table into sub-tables based on most significant bit of the shifted codeword can extend to simple codes with mixed 0-leading and 1-leading such as the reversible VLC of MPEG4 which essentially uses number of consecutive 0s or the location of a 0 in a string of 1s.

## Claims

1. A method of decoding variable length codes, comprising:
(a) constructing a first code table and a first control table from a variable length code table;
(b) applying a decode function to an input bitstream, said input bitstream encoded including codewords from said variable length code table, and said decode function interpreting said bitstream using said first control table and said first code table to decode said codewords.

2. The method of claim 1, wherein:
(a) said first control table includes a shift-offset pair for each sub-table of said variable length code table where said sub-tables are a partitioning based on binary interpretation of codewords in said variable length code table; and
(b) said first code table includes a length-pattern pair for each codeword in said variable length code table and is indexed by binary interpretation and said shift-offset.
